(19) Europäisches Patentamt
European Patent Office
Office européen des brevets

(11) **EP 2 926 244 B1**

(12) **EUROPEAN PATENT SPECIFICATION**

(45) Date of publication and mention
of the grant of the patent:
**26.07.2017 Bulletin 2017/30**

(51) Int Cl.:
**G06T 17/00** (2006.01) **G06T 19/20** (2011.01)

(21) Application number: **12889351.8**

(86) International application number:
**PCT/CN2012/085615**

(22) Date of filing: **30.11.2012**

(87) International publication number:
**WO 2014/082278 (05.06.2014 Gazette 2014/23)**

(54) **METHOD AND APPARATUS FOR CREATING 3D MODEL**

VERFAHREN UND VORRICHTUNG ZUR ERZEUGUNG EINES 3D-MODELLS

PROCÉDÉ ET APPAREIL POUR CRÉER UN MODÈLE 3D

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**07.10.2015 Bulletin 2015/41**

(73) Proprietor: **Thomson Licensing
92130 Issy-les-Moulineaux (FR)**

(72) Inventors:
• **CAI, Kangying
Beijing 100192 (CN)**
• **LUO, Tao
Beijing 100192 (CN)**
• **TIAN, Jiang
Beijing 100192 (CN)**

(74) Representative: **Vidon Brevets & Stratégie
16B, rue de Jouanet
B.P. 90333
Technopole Atalante
35703 Rennes Cedex 7 (FR)**

(56) References cited:
**WO-A1-2011/091717 WO-A1-2012/000132
CN-A- 101 887 597 US-A1- 2012 300 020**

• **MITRA N J ET AL: "Partial and approximate symmetry detection for 3D geometry", ACM TRANSACTIONS ON GRAPHICS ACM USA, vol. 25, no. 3, July 2006 (2006-07), pages 560-568, XP002759313, ISSN: 0730-0301**
• **ALIAGA D G ET AL: "Style Grammars for Interactive Visualization of Architecture", IEEE TRANSACTIONS ON VISUALIZATION AND COMPUTER GRAPHICS, IEEE SERVICE CENTER, LOS ALAMITOS, CA, US, vol. 13, no. 4, 1 July 2007 (2007-07-01), pages 786-797, XP011190849, ISSN: 1077-2626, DOI: 10.1109/TVCG.2007.1024**
• **MING-MING CHENG ET AL: "RepFinder", ACM TRANSACTIONS ON GRAPHICS (TOG), ACM, US, vol. 29, no. 4, 26 July 2010 (2010-07-26), pages 1-8, XP058041100, ISSN: 0730-0301, DOI: 10.1145/1778765.1778820**
• **MARTIN BOKELOH ET AL: "A connection between partial symmetry and inverse procedural modeling", ACM TRANSACTIONS ON GRAPHICS (TOG), ACM, US, vol. 29, no. 4, 26 July 2010 (2010-07-26), pages 1-10, XP058041121, ISSN: 0730-0301, DOI: 10.1145/1778765.1778841**
• **FEI HOU ET AL: "Drawing-Based Procedural Modeling of Chinese Architectures", IEEE TRANSACTIONS ON VISUALIZATION AND COMPUTER GRAPHICS, IEEE SERVICE CENTER, LOS ALAMITOS, CA, US, vol. 18, no. 1, 1 January 2012 (2012-01-01), pages 30-42, XP011408922, ISSN: 1077-2626, DOI: 10.1109/TVCG.2011.22**

**Description**

Field of the invention

The present invention relates to 3D model creation. In particular, the present invention relates to a method and apparatus for creating a 3D model from an input 3D model based on repetitive structures of the input 3D model.

Background

Movie/game making always requires a creation of lots of new 3D models. However, it is a time-consuming work to create a high quality 3D model, which requires substantial artistic and technical skills. Consequently, a lot of recent work has focused on "intelligent" modeling tools that to some extend "understand" the structure of 3D shapes.

Repetitive structures are ubiquitous not only in nature, e.g. in biology and physics, but also in other fields, such as engineering and art. Repetitive structures are very common in man-made objects, and fundamental e.g. in almost all design styles in architecture. In addition, repetitive structures are fundamental in almost all design styles in architecture.

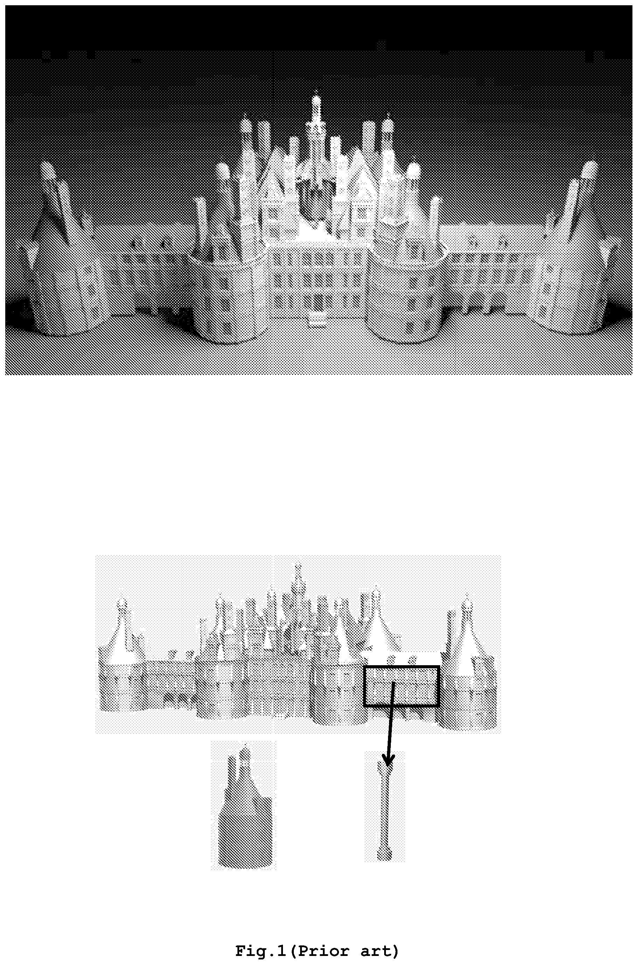

Figure 1 shows the model of a castle with two examples of repetitive structures. The castle model comprises a plurality of components, such as structures of pillar, tower, window, etc. As shown in Figure 1, the structure of a pillar is reproduced multiple times on the walls of each of the four towers. The basic structure of the pillar is shown at the lower right of the figure. In addition, each tower itself comprises a repetitive structure illustrated by the lower left part of the figure. Depending on its position, this basic tower structure is complemented with smaller structures such as some of the windows placed on the roofs. Figure 1 only shows one example of a 3D model with repetitive structures. It could be appreciated that lots of 3D models include hierarchical repetitive structures.

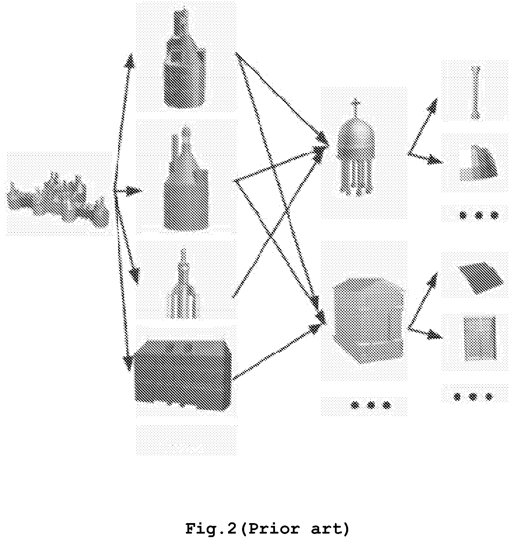

Figure 2 is an exemplary diagram showing hierarchical repetitive structures in the castle model in Figure 1. As shown in Figure 2, the castle model contains some large scale repetitive structures as shown in the second column in Figure 2. These repetitive structures may further include small scale repetitive structures as shown in the third column in Figure 2. The arrows between the second and third columns show the inclusion relationship between the two columns.

A publication by Bokeloh, M., Wand ,M. and Seidel ,H. P. (2010), "A connection between partial symmetry and inverse procedural modeling", Transactions on Graphics (TOG) 29(4): 1-10) proposes to achieve inverse procedural modelling to find the structural information of the existing 3D model by finding a set of rules that describe objects similar to the exemplar, given a piece of exemplar 3D geometry. This publication proposes to define the local similarity during geometry synthesis based on the repetitive structure information. However, it can only make use of limited types of structural information in the input 3D model such as repetitive structures of single scale

Document WO2012000132A1 discloses a method for detecting repetitive structures in 3D mesh models wherein repetitive structures are detected at different scale in the 3D model by sampling the 3D model using different sampling step sizes.

Document "Partial and Approximate symmetry detection for 3D geometry", N. J. Mitra, L.J. Guibas and M. Pauly, ACM Transactions on Graphics ACM USA, vol. 25, n°3, July 2006, pages 560-568, discloses an algorithm that processes geometric models and efficiently discovers and extracts a symmetry graph representation of the model.

Document "RepFinder: Finding Approximately Repeated Scene Elements for Image Editing", M-M. Cheng, F-L. Zhang, N.J. Mitra, X. Huang, S-M. Hu, ACM Transactions on Graphics ACM US, vol. 29, n°4, July 2010, pages 1-8, discloses a method for detecting repetitive elements in 2D images by considering the shape of the elements.

Document "Drawing-based procedural modeling of Chinese Architectures", F. Hou, H. Qin, IEEE Transactions on visualization and computer graphics, vol.18, n°1, January 2012, pages 30-42, discloses a modeling framework to build 3D models of Chinese architectures from elevation drawing, by clustering small horizontal regions of the elevation drawing to form architectural components with maximum repetition, which then serve as building blocks for 3D model generation.

Summary of the Invention

The present invention provides a method and apparatus for creating a 3D model from an input 3D model based on repetitive structures of the input 3D model according to claims.

Brief description of the drawings

Exemplary embodiments of the invention are described with reference to the accompanying drawings, which show in:

Figure 1 shows the model of a castle with two examples of repetitive structures;

Figure 2 is an exemplary diagram showing examples of hierarchical repetitive structure in the castle model of Figure 1;

Figure 3 is a flow chart showing a method for creating a 3D mode according to an embodiment of the present invention;

Figure 4 is a block diagram showing an example of the hierarchical repetitive structure graph organized according to an embodiment of the present invention;

Figure 5 is a flow chart showing an example of a method for recalculating the pose of those components that need to be updated;

Figure 6 is an exemplary diagram showing a 2D illustration of calculating the new position of the first component;

Figure 7 is an exemplary diagram showing a 2D illustration of calculating the new position of the child components other than the first one; and

Figure 8 shows an apparatus for creating a 3D model from an input 3D model according to an embodiment of the present invention.

Detailed description of the invention

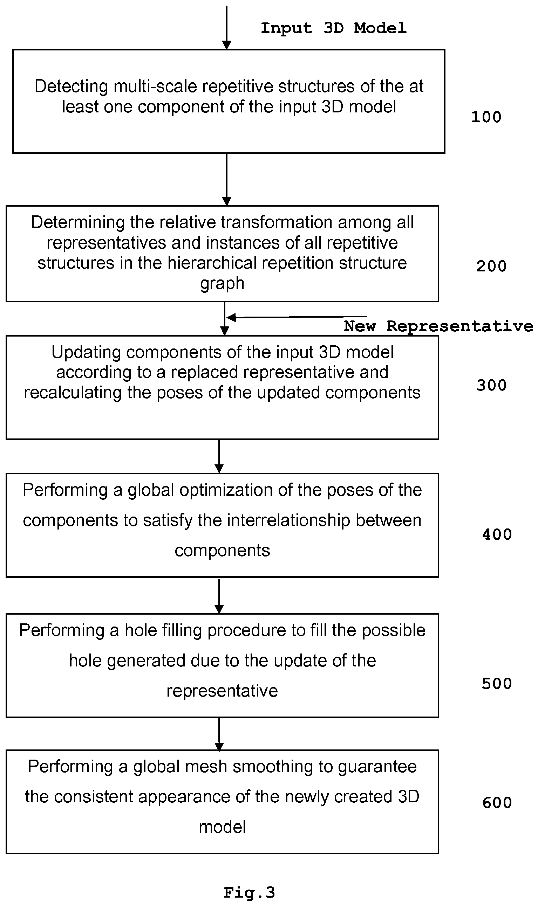

Figure 3 is a flow chart showing a method for creating a 3D model according to an embodiment of the present invention.

The input of the method is an input 3D model which comprises at least one component.

As shown in Figure 3, at the step 100, multi-scale repetitive structures of the at least one component of the input 3D model are detected. For purpose of the multi-scale repetitive structures discovery of the input 3D model, the method described in the international patent application PCT/CN2010/000984, Kangying Cai et al, "Method and apparatus for detecting repetitive structures in 3D mesh models" can be used.

According to PCT/CN2010/000984, an efficient and multi-scale method has been proposed to detect repetitive structures in 3D models, wherein an iterative uniform sampling method with a decreasing sampling step size is used. A given 3D mesh model is uniformly sampled with an initial sampling step size, which is relatively large. Then, the sampling points are clustered according to their curvature, and then transformations are determined between sampling points that belong to the same cluster. These are so-called candidate transformations. Thus, the candidate transformations need to be determined only for those sampling point pairs where both points have similar curvature. Such clustering step not only improves the algorithm efficiency, but also increases the algorithm accuracy. The transformation space, which is constructed by all the transformations calculated before, contains less noise elements than it would if the sampling step size was smaller. Thus, a subsequent clustering step will be more likely to discover all the repetitive structures. If the model comprises repetitive structures, the usual result of such clustering is that one or more distinct clusters will emerge. In the next step, the (most relevant) clusters are selected, and the corresponding transformations and sampling point pairs are assumed to indicate a repetitive structure. The most relevant clusters are those which are most significant and apparent. Other transformations that don't belong to a cluster are discarded. This procedure is iteratively executed with a decreasing sampling step. Each iteration skips repetitions, and only processes remaining parts of the model and representatives of the representative structures that were detected in the previous iteration. Thus, also multi-scale repetitive structures on the 3D model can be discovered. The iterative process stops when the number of repetitive structures is stable, or when a pre-defined minimum sampling step size is reached. It is also possible to define a time-out, measure the runtime of the process, and terminate the process when the runtime exceeds the time-out. Based on the foregoing, a multi-scale repetitive structures detection of the input 3D mesh model can be achieved by PCT/CN2010/000984, the result of which can be used in the embodiment of the present invention.

The repetitive structures and their hierarchical relationship detected with the method in the above international patent application can be organized into a graph, which is called hierarchical repetitive structure graph.

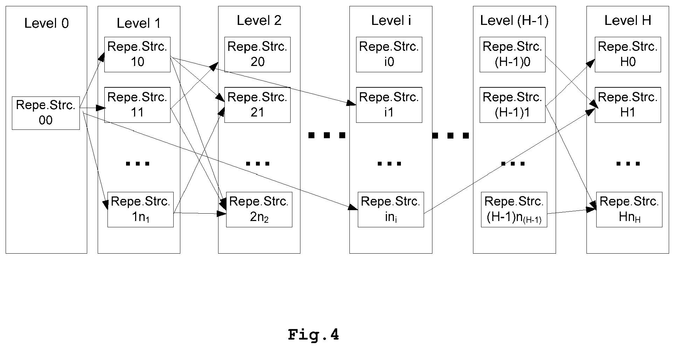

Figure 4 is a block diagram showing an example of the hierarchical repetitive structure graph organized according to an embodiment of the present invention. As shown in Figure 4, there are several levels in the graph. The number of levels is determined once the iterative detecting process stops under a condition that the number of repetitive structures is stable, or a pre-defined minimum sampling step size is reached, or the runtime exceeds the time-out. Suppose the number of the levels in the graph is H+1. The top level (level 0) corresponds to the biggest scale of the repetitive structures that can be discovered, which is the scale of the input model when the whole input model is regarded as the biggest repetitive structure. The bottom level (level H) corresponds to the smallest scale of the repetitive structures that can be discovered from the input model. Each node in the graph represents a repetitive structure, which consists of a representative and several instances, if any. One component of a repetitive structure can be selected as a representative and other components of the repetitive structure are instances in this case. The nodes belonging to the same level correspond to all repetitive structures discovered at the same scale. The only node in level 0 only includes a representative, which is the whole input model, and has no instance. An arrow in the graph means the repetitive structure representative of the starting node includes the repetitive structure representative and/or instances of the end node. The start and end node of an arrow are called the parent and child repetitive structure respectively.

An arrow in Figure 4 records the following information:

Whether or not the parent repetitive structure representative includes the child repetitive structure representative; and
Which child repetitive structure instances are included by the parent node representative, if any.

A repetitive structure representative in the hierarchical repetition structure graph is composed of not only its representative geometry but also some instances of its child repetitive structures, if any. A repetitive structure instance is represented by the transformation between the corresponding representative and itself.

Please go back to Figure 3. At the next step 200, the relative transformation among all representatives and instances of all repetitive structures in the hierarchical repetition structure graph is determined. As an example, the relative transformation can be described by constructing another graph, which is called component graph in the embodiment. Methods for constructing the component graph is known in the art. For example, the method described in Section 3 of V. Kraevoy and A. Sheffer, "Cross-parameterization and compatible remeshing of 3D models" could be used for this purpose. Each node in the component graph corresponds to one repetitive structure representative or one repetitive structure instance.

The edges of the component graph need to satisfy the following requirements:

A representative or an instance is directly connected to the instances/representatives which are closest to it;
A repetitive structure representative should be directly connected to at least one instance of the same repetitive structure;
An instance should be directly connected to the representative or at least one instance of the same repetitive structure;
Any component pair among all the components belonging to the child repetitive structures of the same parent repetitive structure should be reachable; and
For two repetitive structures belonging to the same level, there is at least one edge connecting their representative or instances.

Those requirements are to make sure that:

Any two components belonging to the same repetitive structure can be connected by the edges of the component graph;
Any two components belonging to the same parent repetitive structure can be connected by the edges of the component graph; and
Any two components belonging to the same level of the hierarchical repetition structure graph can be connected by the edges of the component graph.

The distance between two nodes is the distance between positions of their components(representative or instance). If the positions of two components can be connected by a marching edge path which consists of the edges of the input 3D model along the surface of the input 3D model, their distance is the length of the marching edge path. Otherwise, the distance is the Euclidean distance of the two positions. The edges of the component graph can be built using a method similar to the one described in the publication of V. Kraevoy and A. Sheffer, "Cross-parameterization and compatible remeshing of 3D models", ACM Trans. Graph., 2004, pp.861-869.

The distance between two nodes is the Euclidean distance between their centers. Then the initial component graph is built by connecting each node with its nearest node. The shortest distance between two nodes can be calculated by Dijkstra algorithm(http://en.wikipedia.org/wiki/Dijkstra%27s algorith m). Then edges are added between two components when the above requirements cannot be satisfied.

Suppose one node $Node\_i$ in the component graph corresponds to a component $Comp\_i$, $Node\_i$ records the following information:

$CompPos\_i$, the position of $Comp\_i$;
The principal directions ($PriDir0$ and $PriDir1$) and principle curvatures ($PriCur0$ and $PriCur1$) of $Comp\_i$.

For two connected nodes $Node\_i1$ and $Node\_i2$, suppose the corresponding components are $Comp\_i1$ and $Comp\_i2$, edge ($Node\_i1$, $Node\_i2$) records the following information:

The distance between $Comp\_i1$ and $Comp\_i2$;
($CompPos\_i1$, $CompPos\_i2$) in the local coordinate system of $Comp\_i1$; and
($CompPos\_i2$, $CompPos\_i1$) in the local coordinate system of $Comp\_i2$.

At the next step 300, components of the input 3D model are updated according to a replaced representative, and the poses(position, orientation and scaling) of the updated components are recalculated. That is, those nodes in the component graph whose representatives are replaced by new representatives and/or child nodes are updated. The representative could be replaced by a user for purpose of creating a new 3D model based on the input 3D model.

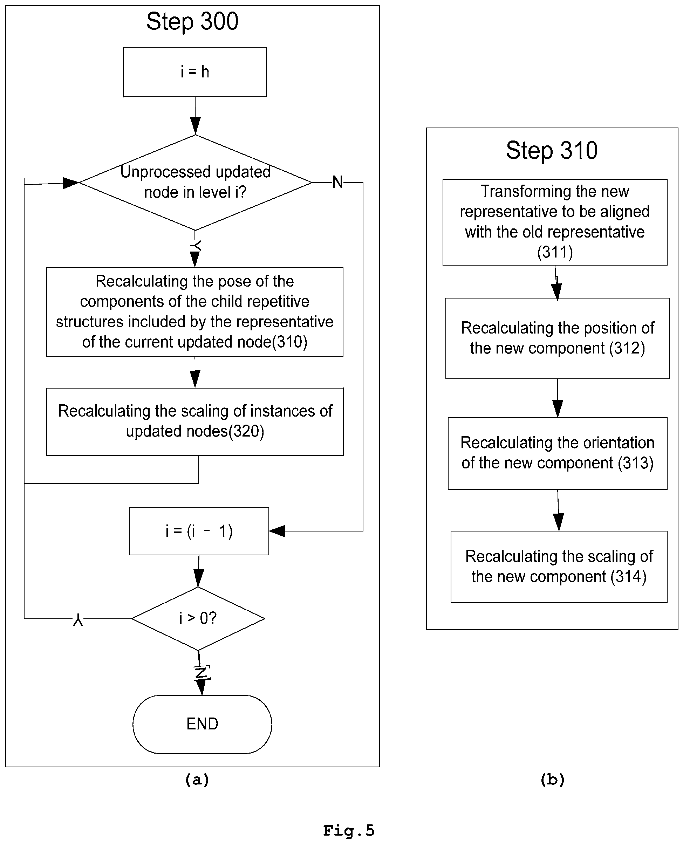

Figure 5 is a flow chart showing an example of a method for the above step 300 for recalculating the pose of updated components. As shown in Figure 5, the process for recalculating the pose of a component is performed in the bottom to top sequence in the hierarchical repetitive structure graph.

As shown in Figure 5(a), firstly at the step 310, the pose of the components of the child repetitive structures included by the representative of the current updated node is recalculated.

Figure 5(b) is an exemplary flow chart showing the detailed steps for implementing the above step 310 to recalculate the pose of the components of the child repetitive structures included by the representative of the current updated node.

As shown in Figure 5(b) at the step 311 the new representative, for example, inputted by the user, is transformed to be aligned with the old representative. The position/orientation/scaling of the old representative is calculated by principle component analysis (PCA).

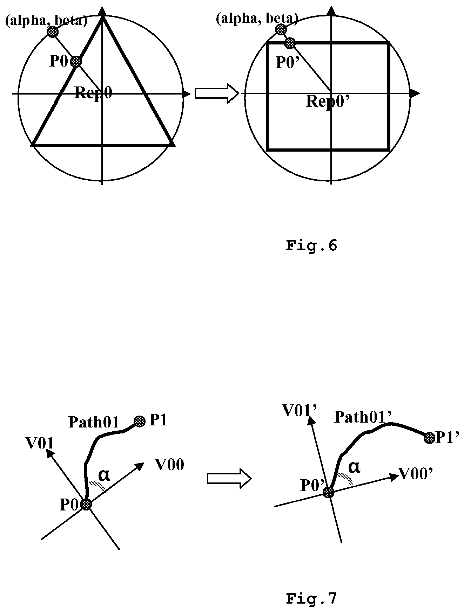

At step 312 the position of the new component is recalculated. The new position of the first component can be calculated by the method shown in Figure 6. The positions of other new components are calculated by the method shown in Figure 7. Suppose two components, Comp0 and Comp1, are directly connected in the component graph. If the new position of Comp0 is already calculated, the new position of Comp1 can be calculated. Note the old position of Comp0 and Comp1 as P0 and P1 respectively. Comp0's new position is P0'. Path01 is the marching path between P0 and P1. V00 and V01, the principle directions at P0, construct the local coordinate system of P0. $\alpha$ is the included angle between V00 and Path01. C00 and C01 are the principle curvatures at P0. V00' and V01', the principle directions at P0', construct the local coordinate system of P0'. Path 01' is the marching path starting from P0' and the included angle between P0' and V00' is $\alpha$. Note the two principle curvatures at P0' as C00' and C01'. Suppose the length of Path01 is L, L', the length of Path01', is calculated by

$$\mathtt{L' \; = \; (C00'/C00+C01'/C01)/2 \; * \; L.}$$

Then P1', the new position of Comp1, is got by starting from P0' walking along Path01' for L' distance.

After the position of the new component is calculated, at step 313 the orientation of the new component can be calculated from the relative orientation of Comp1 and the local coordinate system at P1'. At step 314, the scaling of the new component can be calculated from the relative scaling of Comp1 and the local principle curvatures at P1'.

Please return to Figure 5(a), at the next step 320 the scaling of instances of updated nodes is recalculated so that they have the similar oriented bounding box of the old instances.

Please return back to Figure 3, with the steps 100-300, a newly created 3D model is obtained with updated components and recalculated poses of the updated components. At step 400 next to the step 300, a global optimization of the poses of the components is performed to satisfy the interrelationship between components as much as possible. This is because that, at the step 300, only part of the interrelationship of the component graph is used to update the poses of components, by which the poses of new components may not satisfy all interrelationship defined in the component graph. After the optimization, in order to record the hierarchical repetition structure of the new 3D model, the hierarchical repetitive structure graph according can be updated according to the new component poses.

At the next step 500, a hole filling procedure is performed to fill the possible hole generated due to the update of the representative. Known methods in the art could be used for purpose of the hole filling procedure, such as the method described in James Davis, Stephen R. Marschner, Matt Garr, and Marc Levoy, Filling holes in complex surfaces using volumetric diffusion, First International Symposium on 3D Data Processing, Visualization, and Transmission, Padua, Italy, June 19-21, 2002.

At the next step 600, a global mesh smoothing is performed to guarantee the consistent appearance of the newly created 3D model. Known methods in the art could be used for purpose of the hole filling procedure, such as the method described in T. R. Jones, F. Durand, and Mathieu Desbrun. Non-iterative, feature preserving mesh smoothing. In Proceedings of SIGGRAPH 2003, pp.943-949, 2003.

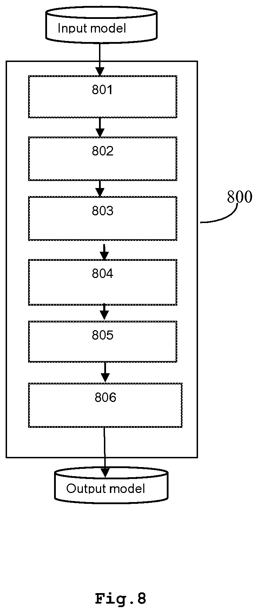

Figure 8 shows an apparatus 800 for creating a 3D model from an input 3D model according to an embodiment of the present invention. The apparatus 800 comprises detecting means 801 for detecting repetitive structures of the at least one component of the input 3D model and hierarchical relationship of the repetitive structures. As described above, each repetitive structure comprises a component set as a representative and one or more components, if any, set as an instance.

The apparatus 800 further comprises determining means 802 for determining a relative transformation among all representatives and instances of all the repetitive structures of the input 3D model; and creating means for updating relevant components of the input 3D model according to a change of a representative in the repetitive structures and recalculating the poses of the updated components as a function of the determined relative transformation to create the 3D model.

In the 3D model created by the apparatus 800, only part of the determined relative transformation is used to update the poses of components. In order that the poses of new components in the created 3D model satisfy all relative transformation of all the repetitive structures of the input 3D model, the apparatus 800 further comprises global optimization means 804 for performing a global optimization of the poses of all the components of the created 3D model as a function of the determined relative transformation.

In order to fill the possible hole generated due to the update of the representative, the apparatus 800 may further comprises hole filling means 805 for performing a hole filling procedure to the created 3D model.

In order to guarantee the consistent appearance of the created 3D model, the apparatus 800 may further comprises global mesh smoothing means 806 for performing a global mesh smoothing to the created 3D model.

It is to be understood that the present invention may be implemented in various forms of hardware, software, firmware, special purpose processors, or a combination thereof. The present invention has been described purely by way of example, and modifications of detail can be made without departing from the scope of the invention. Each feature disclosed in the description and (where appropriate) the claims and drawings may be provided independently or in any appropriate combination. Features may, where appropriate be implemented in hardware, software, or a combination of the two. Reference numerals appearing in the claims are by way of illustration only and shall have no limiting effect on the scope of the claims.

**Claims**

1. Method for creating a 3D model from an input 3D model with at least one component, comprising:

    detecting repetitive structures of the at least one component of the input 3D model and hierarchical relationship of the repetitive structures, each repetitive structure comprising a component set as a representative and one or more components, if any, set as instances (100), wherein a hierarchical repetition structure graph is formed based on the detected repetitive structures and hierarchical relationship between the repetitive structures, a node in the hierarchical repetitive structure graph representing a repetitive structure consisting of a representative and several instances if any;
    determining a relative transformation among all representatives and instances of all the repetitive structures of the input 3D model (200),
    said method being **characterized in that**:

        - a component graph is formed to describe the relative transformation among all representatives and instances of all repetitive structures in the hierarchical repetition structure graph and each node in the component graph corresponding to one repetitive structure representative or one repetitive structure instance; and **in that** said method comprises:

            - updating relevant components of the input 3D model according to a change of a representative in the repetitive structures and recalculating the poses of the updated components as a function of the determined relative transformation to create the 3D model (300).

2. Method according to claim 1, further comprising:

    performing a global optimization of the poses of all the components of the created 3D model as a function of the determined relative transformation (400) so as to satisfy the interrelationships between components defined in the component graph.

3. Method according to claim 1 or 2, further comprising:

    performing a hole filling procedure to the created 3D model to fill the possible hole generated due to the update of the representative (500).

4. Method according to any one of claims 1-3, further comprising:

    performing a global mesh smoothing to the created 3D model to guarantee the consistent appearance of the newly created 3D model (600).

**5.** Method according to claim 1, wherein the step of updating components of the input 3D model and recalculating the poses of the updated components comprises:

recalculating the pose of the components of the child repetitive structures included by the representative of the current updated component in the hierarchical relationship between the repetitive structures (310); and recalculating the scaling of instances of updated components (320).

**6.** Method according to claim 5, wherein the step of recalculating (310) the pose of the components of the child repetitive structures comprises:

aligning the changed representative with the representative (311);
recalculating the position of the components of the child repetitive structures (312);
recalculating the orientation of the components of the child repetitive structures (313);and
recalculating the scaling of the components of the child repetitive structures (314).

**7.** Apparatus (800) for creating a 3D model from an input 3D model with at least one component, comprising:

means (801) for detecting repetitive structures of the at least one component of the input 3D model and hierarchical relationship of the repetitive structures, each repetitive structure comprising a component set as a representative and one or more components, if any, set as instances wherein a hierarchical repetition structure graph is formed based on the detected repetitive structures and hierarchical relationship between the repetitive structures, a node in the hierarchical repetitive structure graph representing a repetitive structure consisting of a representative and several instances if any;
means (802) for determining a relative transformation among all representatives and instances of all the repetitive structures of the input 3D model,
said apparatus being **characterized in that**:

- a component graph is formed to describe the relative transformation among all representatives and instances of all repetitive structures in the hierarchical repetition structure graph and each node in the component graph corresponding to one repetitive structure representative or one repetitive structure instance; and **in that** said apparatus comprises:

- means (803) for updating relevant components of the input 3D model according to a change of a representative in the repetitive structures and recalculating the poses of the updated components as a function of the determined relative transformation to create the 3D model.

**8.** Apparatus (800) according to claim 7, further comprising:

means (804) for performing a global optimization of the poses of all the components of the created 3D model as a function of the determined relative transformation so as to satisfy the interrelationships between components defined in the component graph.

**9.** Apparatus (800) according to claim 7 or 8, further comprising:

means (805) for performing a hole filling procedure to the created 3D model to fill the possible hole generated due to the update of the representative.

**10.** Apparatus (800) according to any one of claims 7 to 9, further comprising:

means (806) for performing a global mesh smoothing to the created 3D model to guarantee the consistent appearance of the newly created 3D model.

**Patentansprüche**

**1.** Verfahren zum Erzeugen eines 3D-Modells aus einem Eingangs-3D-Modell mit mindestens einer Komponente, wobei das Verfahren umfasst:

Detektieren wiederholter Strukturen der mindestens einen Komponente des Eingangs-3D-Modells und einer hierarchischen Beziehung der wiederholten Strukturen, wobei jede wiederholte Struktur eine Komponente, die als ein Repräsentant eingestellt ist, und eine oder mehrere Komponenten, wenn überhaupt, die als Instanzen (100) eingestellt sind, umfasst, wobei auf der Grundlage der detektierten wiederholten Strukturen und der hierarchischen Beziehung zwischen den wiederholten Strukturen ein Graph einer hierarchischen Wiederholungsstruktur gebildet wird, wobei ein Knoten in dem Graphen der hierarchischen wiederholten Struktur eine wiederholte Struktur repräsentiert, die aus einem Repräsentanten und mehreren Instanzen, wenn überhaupt, besteht;

Bestimmen einer relativen Transformation zwischen allen Repräsentanten und Instanzen aller wiederholten Strukturen des Eingangs-3D-Modells (200),

wobei das Verfahren **dadurch gekennzeichnet ist, dass**:

- zur Beschreibung der relativen Transformation zwischen allen Repräsentanten und Instanzen aller wiederholten Strukturen in dem Graphen der hierarchischen Wiederholungsstruktur und jedem Knoten in dem Komponentengraphen, der einem Repräsentanten der wiederholten Struktur oder einer Instanz der wiederholten Struktur entspricht, ein Komponentengraph gebildet wird; und dadurch, dass das Verfahren umfasst:

- Aktualisieren relevanter Komponenten des Eingangs-3D-Modells in Übereinstimmung mit einer Änderung eines Repräsentanten in den wiederholten Strukturen und Neuberechnen der Posen der aktualisierten Komponenten in Abhängigkeit von der bestimmten relativen Transformation zum Erzeugen des 3D-Modells (300).

2. Verfahren nach Anspruch 1, das ferner umfasst:

Ausführen einer globalen Optimierung der Posen aller Komponenten des erzeugten 3D-Modells in Abhängigkeit von der bestimmten relativen Transformation (400), um die Beziehungen zwischen den in dem Komponentengraphen definierten Komponenten zu erfüllen.

3. Verfahren nach Anspruch 1 oder 2, das ferner umfasst:

Ausführen einer Lochfüllprozedur an dem erzeugten 3D-Modell, um das mögliche wegen der Aktualisierung des Repräsentanten (500) erzeugte Loch zu füllen.

4. Verfahren nach einem der Ansprüche 1-3, das ferner umfasst:

Ausführen einer Glättung des globalen Flächennetzes an dem erzeugten 3D-Modell, um das konsistente Aussehen des neu erzeugten 3D-Modells sicherzustellen (600).

5. Verfahren nach Anspruch 1, wobei der Schritt des Aktualisierens von Komponenten des Eingangs-3D-Modells und des Neuberechnens der Posen der aktualisierten Komponenten umfasst:

Neuberechnen der Pose der Komponenten der wiederholten Nachfolgerstrukturen, die durch den Repräsentanten der aktuell aktualisierten Komponente in der hierarchischen Beziehung zwischen den widerholten Strukturen enthalten sind (310); und
Neuberechnen der Skalierung der Instanzen der aktualisierten Komponenten (320)

6. Verfahren nach Anspruch 5, wobei der Schritt des Neuberechnens (310) der Pose der Komponenten der wiederholten Nachfolgerstrukturen umfasst:

Ausrichten des geänderten Repräsentanten auf den Repräsentanten (311)
Neuberechnen der Position der Komponenten der wiederholten Nachfolgerstrukturen (312);
Neuberechnen der Orientierung der Komponenten der wiederholten Nachfolgerstrukturen (313); und
Neuberechnen der Skalierung der Komponenten der wiederholten Nachfolgerstrukturen (314).

7. Vorrichtung (800) zum Erzeugen eines 3D-Modells aus einem Eingangs-3D-Modell mit mindestens einer Komponente, wobei die Vorrichtung umfasst:

Mittel (801) zum Detektieren wiederholter Strukturen der mindestens einen Komponente des Eingangs-3D-Modells und einer hierarchischen Beziehung der wiederholten Strukturen, wobei jede wiederholte Struktur eine Komponente, die als ein Repräsentant eingestellt ist, und eine oder mehrere Komponenten, wenn überhaupt, die als Instanzen eingestellt sind, umfasst, wobei auf der Grundlage der detektierten wiederholten Strukturen und der hierarchischen Beziehung zwischen den wiederholten Strukturen ein Graph einer hierarchischen Wiederholungsstruktur gebildet wird, wobei ein Knoten in dem Graphen der hierarchischen wiederholten Struktur eine wiederholte Struktur repräsentiert, die aus einem Repräsentanten und mehreren Instanzen, wenn überhaupt, besteht;

Mittel (802) zum Bestimmen einer relativen Transformation zwischen allen Repräsentanten und Instanzen aller wiederholten Strukturen des Eingangs-3D-Modells,

wobei die Vorrichtung **dadurch gekennzeichnet ist, dass**:

- zur Beschreibung der relativen Transformation zwischen allen Repräsentanten und Instanzen aller wiederholten Strukturen in dem Graphen der hierarchischen Wiederholungsstruktur und jedem Knoten in dem Komponentengraphen, der einem Repräsentanten der wiederholten Struktur oder einer Instanz der wiederholten Struktur entspricht, ein Komponentengraph gebildet wird; und dadurch, dass die Vorrichtung umfasst:

- Mittel (803) zum Aktualisieren relevanter Komponenten des Eingangs-3D-Modells in Übereinstimmung mit einer Änderung eines Repräsentanten in den wiederholten Strukturen und Neuberechnen der Posen der aktualisierten Komponenten in Abhängigkeit von der bestimmten relativen Transformation zum Erzeugen des 3D-Modells.

8. Vorrichtung (800) nach Anspruch 7, die ferner umfasst:

Mittel (804) zum Ausführen einer globalen Optimierung der Posen aller Komponenten des erzeugten 3D-Modells in Abhängigkeit von der bestimmten relativen Transformation, um die Beziehungen zwischen den in dem Komponentengraphen definierten Komponenten zu erfüllen.

9. Vorrichtung (800) nach Anspruch 7 oder 8, die ferner umfasst:

Mittel (805) zum Ausführen einer Lochfüllprozedur an dem erzeugten 3D-Modell, um das mögliche wegen der Aktualisierung des Repräsentanten erzeugte Loch zu füllen.

10. Vorrichtung (800) nach einem der Ansprüche 7 bis 9, die ferner umfasst:

Mittel (806) zum Ausführen einer Glättung des globalen Flächennetzes an dem erzeugten 3D-Modell, um das konsistente Aussehen des neu erzeugten 3D-Modells sicherzustellen.

**Revendications**

1. Procédé pour créer un modèle 3D à partir d'un modèle 3D d'entrée avec au moins un composant, comprenant :

la détection des structures répétitives du au moins un composant du modèle 3D d'entrée et d'une relation hiérarchique des structures répétitives, chaque structure répétitive comprenant un composant défini comme un représentant et un ou plusieurs composants, le cas échéant, définis comme des instances (100), dans laquelle un graphe de structures de répétition hiérarchiques est créé d'après les structures répétitives détectées et la relation hiérarchique entre les structures répétitives, un noeud dans le graphe de structures de répétition hiérarchiques représentant une structure répétitive consistant en un représentant et en plusieurs instances, le cas échéant ;

la détermination d'une transformation relative entre tous les représentants et toutes les instances de toutes les structures répétitives du modèle 3D d'entrée (200), ledit procédé étant **caractérisé en ce que** :

- un graphe de composants est créé pour décrire la transformation relative entre tous les représentants et toutes les instances de toutes les structures répétitives du graphe de structures de répétition hiérarchiques et chaque noeud du graphe de composants correspond à un représentant de structure répétitive ou une instance de structure répétitive ; et **en ce que** ledit procédé comprend :

- la mise à jour des composants appropriés du modèle 3D d'entrée conformément à un changement de représentant dans les structures répétitives et le recalcul des poses des composants mis à jour en fonction de la transformation relative déterminée pour créer le modèle 3D (300).

2.  Procédé selon la revendication 1, comprenant en outre :

l'exécution d'une optimisation globale des poses de tous les composants du modèle 3D créé en fonction de la transformation relative déterminée (400) de manière à satisfaire les interrelations entre les composants définies dans le graphe de composants.

3.  Procédé selon la revendication 1 ou 2, comprenant en outre :

l'exécution d'une procédure de remplissage de trou sur le modèle 3D créé pour remplir le trou éventuel généré par la mise à jour du représentant (500).

4.  Procédé selon l'une des revendications 1 à 3, comprenant en outre :

l'application d'un lissage de maillage global au modèle 3D créé pour garantir l'aspect homogène du modèle 3D nouvellement créé (600).

5.  Procédé selon la revendication 1, dans lequel l'étape de mise à jour des composants du modèle 3D d'entrée et de recalcul des poses des composants mis à jour comprend :

le recalcul de la pose des composants des structures répétitives enfants incluses par le représentant du composant mis à jour actuel dans la relation hiérarchique entre les structures répétitives (310) ; et
le recalcul de la mise à l'échelle des instances des composants mis à jour (320).

6.  Procédé selon la revendication 5, dans lequel l'étape de recalcul (310) de la pose des composants des structures répétitives enfants comprend :

l'alignement du représentant modifié avec le représentant (311) ;
le recalcul de la position des composants des structures répétitives enfants (312) ;
le recalcul de l'orientation des composants des structures répétitives enfants (313) ; et
le recalcul de la mise à l'échelle des composants des structures répétitives enfants (314).

7.  Appareil (800) pour créer un modèle 3D à partir d'un modèle 3D d'entrée avec au moins un composant, comprenant :

un moyen (801) permettant de détecter des structures répétitives du au moins un composant du modèle 3D d'entrée et une relation hiérarchique des structures répétitives, chaque structure répétitive comprenant un composant défini comme un représentant et un ou plusieurs composants, le cas échéant, définis comme des instances
dans lequel un graphe de structures de répétition hiérarchiques est créé d'après les structures répétitives détectées et la relation hiérarchique entre les structures répétitives, un noeud dans le graphe de structures répétitives hiérarchiques représentant une structure répétitive consistant en un représentant et en plusieurs instances, le cas échéant ;
un moyen (802) permettant de déterminer une transformation relative entre tous les représentants et toutes les instances de toutes les structures répétitives du modèle 3D d'entrée, ledit appareil étant **caractérisé en ce que** :

- un graphe de composants est créé pour décrire la transformation relative entre tous les représentants et toutes les instances de toutes les structures répétitives du graphe de structures de répétition hiérarchiques et chaque noeud du graphe de composants à un représentant de structure répétitive ou une instance de structure répétitive ; et **en ce que** ledit appareil comprend :

- un moyen (803) permettant de mettre à jour les composants appropriés du modèle 3D d'entrée conformément à un changement de représentant dans les structures répétitives et de recalculer les poses des composants mis à jour en fonction de la transformation relative déterminée pour créer le modèle 3D.

**8.** Appareil (800) selon la revendication 7, comprenant en outre :

un moyen (804) permettant d'exécuter une optimisation globale des poses de tous les composants du modèle 3D créé en fonction de la transformation relative déterminée de manière à satisfaire les interrelations entre les composants définies dans le graphe de composants.

**9.** Appareil (800) selon la revendication 7 ou 8, comprenant en outre :

un moyen (805) permettant d'exécuter une procédure de remplissage de trou dans le modèle 3D créé pour remplir le trou éventuel généré par la mise à jour du représentant.

**10.** Appareil (800) selon l'une des revendications 7 à 9, comprenant en outre :

un moyen (806) permettant d'appliquer un lissage de maillage global au modèle 3D créé pour garantir l'aspect homogène du modèle 3D nouvellement créé.

Fig.1(Prior art)

Fig.2(Prior art)

Input 3D Model

```
Detecting multi-scale repetitive structures of the at
least one component of the input 3D model          100
```

```
Determining the relative transformation among all
representatives and instances of all repetitive
structures in the hierarchical repetition structure    200
graph
```

New Representative

```
Updating components of the input 3D model
according to a replaced representative and
recalculating the poses of the updated components    300
```

```
Performing a global optimization of the poses of the
components to satisfy the interrelationship between    400
components
```

```
Performing a hole filling procedure to fill the possible
hole generated due to the update of the
representative                                          500
```

```
Performing a global mesh smoothing to guarantee
the consistent appearance of the newly created 3D    600
model
```

Fig.3

Fig.4

Fig.5

Fig.6

Fig.7

Fig.8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2012000132 A1

- CN 2010000984 W

### Non-patent literature cited in the description

- **BOKELOH, M. ; WAND ,M. ; SEIDEL ,H. P.** A connection between partial symmetry and inverse procedural modeling. *Transactions on Graphics (TOG),* 2010, vol. 29 (4), 1-10
- **N. J. MITRA ; L.J. GUIBAS ; M. PAULY.** Partial and Approximate symmetry detection for 3D geometry. *ACM Transactions on Graphics ACM USA,* July 2006, vol. 25 (3), 560-568
- **M-M. CHENG ; F-L. ZHANG ; N.J. MITRA ; X. HUANG ; S-M. HU.** RepFinder: Finding Approximately Repeated Scene Elements for Image Editing. *ACM Transactions on Graphics ACM US,* July 2010, vol. 29 (4), 1-8
- **F. HOU ; H. QIN.** Drawing-based procedural modeling of Chinese Architectures. *IEEE Transactions on visualization and computer graphics,* January 2012, vol. 18 (1), 30-42
- **V. KRAEVOY ; A. SHEFFER.** Cross-parameterization and compatible remeshing of 3D models. *ACM Trans. Graph.,* 2004, 861-869
- **JAMES DAVIS ; STEPHEN R. MARSCHNER ; MATT GARR ; MARC LEVOY.** Filling holes in complex surfaces using volumetric diffusion. *First International Symposium on 3D Data Processing, Visualization, and Transmission,* 19 June 2002
- **T. R. JONES ; F. DURAND ; MATHIEU DESBRUN.** Non-iterative, feature preserving mesh smoothing. *Proceedings of SIGGRAPH 2003,* 2003, 943-949